**Europäisches Patentamt**

**European Patent Office**

**Office européen des brevets**

(11) Veröffentlichungsnummer: **0 358 937**
**A2**

## (12) EUROPÄISCHE PATENTANMELDUNG

(21) Anmeldenummer: **89114585.6**

(22) Anmeldetag: **07.08.89**

(51) Int. Cl.5: **H05K 3/00**

(30) Priorität: **15.09.88 DE 3831432**

(43) Veröffentlichungstag der Anmeldung:
**21.03.90 Patentblatt 90/12**

(84) Benannte Vertragsstaaten:
**AT BE CH DE FR GB IT LI NL SE**

(71) Anmelder: **Siemens Aktiengesellschaft**
**Wittelsbacherplatz 2**
**D-8000 München 2(DE)**

(72) Erfinder: **Schmidt, Hans-Friedrich, Dr.**
**Graf Tattenbachweg 3b**
**D-8191 Eurasburg(DE)**
Erfinder: **Bednarz, Jürgen, Dr.**
**Enzianstrasse 7**
**D-8122 Penzberg(DE)**
Erfinder: **Der weitere Erfinder hat auf seine**
**Nennung verzichtet**

(54) **Dreidimensionale Leiterplatte.**

(57) Eine dreidimensionale Leiterplatte mit mindestens zwei in verschiedenen Ebenen angeordneten starren Platinenabschnitten (1) und biegbaren Verbindungsabschnitten (2) zwischen benachbarten Platinenabschnitten (1) ist als einstückiges Spritzgußteil aus einer thermoplastischen Formmasse hergestellt. Die biegbaren Verbindungsabschnitte (2) sind dabei als Schwachstellen ausgebildet, deren Stärke (s) geringer ist als die Stärke (S) der starren Platinenabschnitte (1). Bei Verwendung von teilkristallinen oder flüssigkristallinen thermoplastischen Formmassen sind die Verbindungsabschnitte (2) als flexible Filmscharniere ausgebildet, während bei Verwendung vor amorphen thermoplastischen Formmassen die Verbindungsabschnitte (2) erst durch die Einwirkung von Wärme gebogen werden können.

## Dreidimensionale Leiterplatte

Die Erfindung betrifft eine dreidimensionale Leiterplatte mit mindestens zwei in verschiedenen Ebenen angeordneten starren Platinenabschnitten und biegbaren Verbindungsabschnitten zwischen benachbarten Platinenabschnitten.

Planare Leiterplatten mit hohen Bestückungsdichten haben einen Platzbedarf, was beim Einbau in elektrische oder elektronische Geräte zwangsläufig zu einer Vergrößerung des Gerätes oder des entsprechenden Gehäuses führt. Die Form der Geräte ist außerdem durch die Geometrie der planaren Leiterplatten vorgegeben.

Es ist bekannt, daß Leiterplatten mit einem starr-flexiblen Aufbau den Geräteformen beispielsweise in Form einer Schachtel angepaßt werden, d.h. in diesem Fall bestimmt das Gerät die Geometrie der Leiterplatten. Diese bekannte zweidimensionale Leiterplatte besteht prinzipiell aus zwei Grundkörpern, nämlich einer starren Platine und einer auflaminierten flexiblen Folie, wobei sowohl bei der starren Platine als auch bei der flexiblen Folie Ein- oder Mehrfachanordnungen möglich sind. Dabei bildet die starre Platine den Bauteileträger mit einseitigen Kontaktierungen, während die Folie die Leiterbahnen trägt. Die Folie übernimmt also die Aufgabe einer flexiblen Platinenverbindung, die es gestattet, in bestimmten Montageschritten die dem Gerät angepaßte Form herzustellen. Die Geometrie der Platinen, Füge- und Montageteile sowie die Kontaktierungslöcher werden mittels Bohr- und Stanztechnik erzeugt.

Der Erfindung liegt die Aufgabe zugrunde, eine dreidimensionale Leiterplatte mit starren Platinenabschnitten und biegbaren Verbindungsabschnitten zu schaffen, die mit hohen Stückzahlen unter Anwendung einer wirtschaftlichen Technologie hergestellt werden können.

Diese Aufgabe wird erfindungsgemäß dadurch gelöst, daß Platinenabschnitte und Verbindungsabschnitte als einstückiges Spritzgußteil aus einer thermoplastischen Formmasse hergestellt sind, wobei die Verbindungsabschnitte als Schwachstellen mit einer gegenüber der Stärke der Platinenabschnitte geringeren Stärke ausgebildet sind.

Die erfindungsgemäße dreidimensionale Leiterplatte wird also in einem Stück durch Spritzgießen hergestellt, wobei es sich hierbei um eine besonders wirtschaftliche Technologie zur Herstellung spanlos geformter Gegenstände handelt. Voraussetzung für die Anwendung des Spritzgießens ist die Ausbildung der Verbindungsabschnitte als Schwachstellen mit reduzierter Stärke. Diese Schwachstellen ermöglichen dann ein Umbiegen oder Umklappen der starren Platinenbereiche, wobei eine unzulässige Dehnung der im Bereich der Verbindungsabschnitte verlaufenden Leiterbahnen gerade durch die reduzierte Stärke der Schwachstellen verhindert wird. Neben ihrer besonders wirtschaftlichen Herstellung können die erfindungsgemäßen Leiterplatten sowohl zur Geräte-Miniaturisierung als auch zur Verbesserung des Geräte-Designs führen.

Gemäß einer ersten bevorzugten Ausführungsform der Erfindung ist vorgesehen, daß das Spritzgußteil aus einer teilkristallinen oder flüssigkristallinen thermoplastischen Formmasse hergestellt ist und die Verbindungsabschnitte als flexible Filmscharniere ausgebildet sind. Durch die Auswahl von teilkristallinen oder flüssigkristallinen Thermoplasten als Formmasse für das Spritzgießen und die Vorgabe entsprechend unterschiedlicher Stärken für die Platinenabschnitte und die Verbindungsabschnitte entsteht also ein Spritzgußteil, bei welchem starre Platinenabschnitte durch die als Filmscharniere bezeichneten Abschnitte verbunden sind.

Gemäß einer Variante ist vorgesehen, daß das Spritzgußteil aus einer amorphen thermoplastischen Formmasse hergestellt ist und die Verbindungsabschnitte als unter Einwirkung von Wärme biegbare Schwachstellen ausgebildet sind. Durch die Auswahl amorpher Thermoplaste als Formmasse für das Spritzgießen entstehen hier Spritzgußteile, deren als Schwachstellen ausgebildete Verbindungsabschnitte erst durch die Einwirkung von Wärme gebogen werden können und ein bruchsicheres Umbiegen bzw. Umklappen der starren Platinenabschnitte in eine dreidimensionale Form ermöglichen.

Im Hinblick auf das Umbiegen der Verbindungsabschnitte ohne unzulässige Dehnungen der darauf verlaufenden Leiterbahnen hat es sich als günstig herausgestellt, wenn die Verbindungsabschnitte eine Stärke von maximal 0,6 und vorzugsweise von maximal 0,3 mm aufweisen. Als Optimum ist dabei eine Stärke der Verbindungsabschnitte zwischen 0,1 und 0,2 mm anzusehen.

Demgegenüber führt bei den Platinenabschnitten eine Stärke zwischen 0,9 und 1,6 mm bei geringem Materialaufwand zu der gewünschten starren Ausbildung.

Eine weitere Reduzierung der Herstellungskosten wird dann erreicht, wenn die Platinenabschnitte spritzgießtechnisch mitgeformte Kontaktierungslöcher besitzen. In ähnlicher Weise können die Gestaltungsmöglichkeiten des Spritzgießens dann auch dazu ausgewertet werden, die Platinenabschnitte mit spritzgießtechnisch mitgeformten Füge- und Montagehilfen zu versehen.

Ein Ausführungsbeispiel der Erfindung ist in der Zeichnung dargestellt und wird im folgenden näher beschrieben.

Es zeigen:

Figur 1 eine perspektivische Darstellung einer als ebenes Spritzgußteil vorliegenden Leiterplatte mit fünf starren Platinenabschnitten und vier flexiblen Verbindungsabschnitten,

Figur 2 eine Seitenansicht des in Figur 1 dargestellten Spritzgußteils,

Figur 3 im Detail den Übergangsbereich zwischen Platinenabschnitt und Verbindungsabschnitt des in Figur 1 dargestellten Spritzgußteils und

Figur 4 das in Figur 1 dargestellte Spritzgußteil als dreidimensionale Leiterplatte in einer endmontierten bzw. umgeklappten Schachtelform.

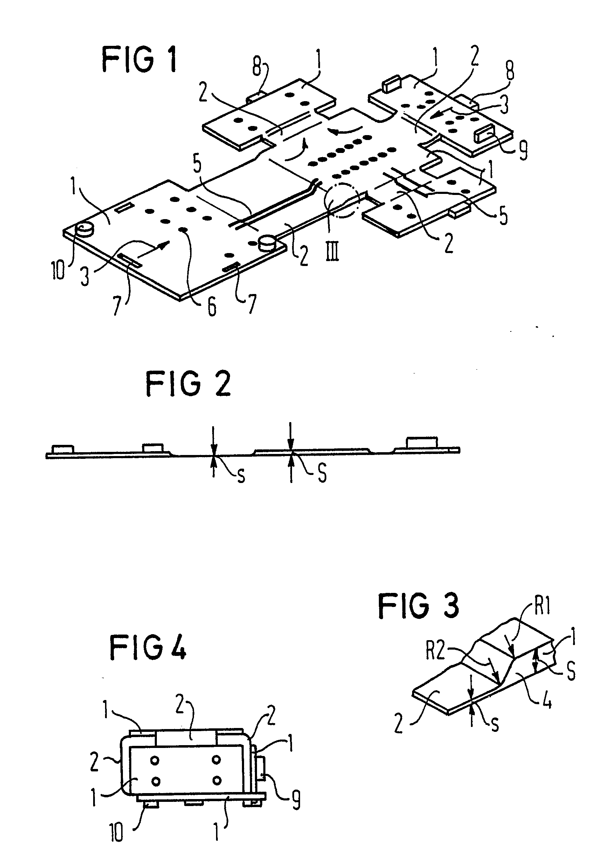

Figur 1 zeigt ein eben ausgebreitetes Spritzgußteil, bei welchem insgesamt fünf starre Platinenabschnitte 1 über als flexible Filmscharniere ausgebildete Verbindungsabschnitte 2 einstückig miteinander verbunden sind. Wie es insbesondere aus der in Figur 2 dargestellten Seitenansicht und der in Figur 3 dargestellten Einzelheit III ersichtlich ist, sind die Verbindungsabschnitte 2 als Schwachstellen aufzufassen, deren Stärke s wesentlich geringer ist als die Stärke S der Platinenabschnitte 1. Im Spritzwerkzeug sind die Platinenabschnitte 1 so angeordnet, daß das spätere Biegen der Filmscharniere bzw. Verbindungsabschnitte 2 parallel zu der durch Pfeile aufgezeigten Spritzgieß-Fließfront 3 erfolgt. Gemäß Figur 3 sind die Übergangsbereiche 4 zwischen den Platinenabschnitten 1 und den Verbindungsabschnitten 2 mittels Radien R1 und R2 dermaßen geformt, daß sowohl ein bruchsicheres Umklappen der starren Platinenabschnitte 1 zu einer dreidimensionalen der Gerätegeometrie entsprechenden Form als auch eine beidseitige Metallisierung und Strukturierung der in Figur 1 andeutungsweise aufgezeigten Leiterbahnen 5 möglich ist.

Figur 1 zeigt ferner, daß das dargestellte Spritzgußteil mit Kontaktierungslöchern 6, Fügehilfen in Form von Durchbrüchen 7 und zugeordneten Ansätzen 8 sowie kubischen und zylindrischen Montagehilfen 9 bzw. 10 versehen ist, die alle spritzgießtechnisch mitgeformt worden sind.

Bei dem in Figur 1 eben ausgebreiteten Spritzgußteil werden der rechte Platinenabschnitt 1 sowie der vordere Platinen abschnitt 1 und der hintere Platinenabschnitt 1 über die zugeordneten flexiblen Verbindungsabschnitte 2 jeweils um 90° nach unten geklappt, während der linke Platinenabschnitt 1 um einen Winkel von 180° nach unten umgebogen und mit seinen drei Durchbrüchen 7 auf die zugeordneten Ansätze 8 der drei senkrechten Platinenabschnitte 1 gedrückt wird. Dabei entsteht dann die in Figur 4 dargestellte dreidimensionale schachtelförmige Leiterplatte mit fünf starren Platinenabschnitten 1 und vier flexiblen Verbindungsabschnitten 2. Hierbei wird eine Seitenwand dieser kubischen Schachtel durch den um 180° umgebogenen Verbindungsabschnitt 2 gebildet.

Bei dem vorstehend beschriebenen Ausführungsbeispiel besteht das Spritzgußteil aus einem teilkristallinen Thermoplast wie z.B. Polyamid. Die Verwendung eines flüssigkristallinen Thermoplasts als Material für das Spritzgußteil, wie z.B. die unter dem Handelsnamen "Vectra" von der Firma Celanese, USA vertriebene Formmasse ist ebenfalls möglich. Die Stärke S der Platinenabschnitte 1 beträgt bei dem dargestellten Ausführungsbeispiel beispielsweise 1,4 mm, während sich für die Verbindungsabschnitte 2 eine Stärke von 0,15 mm als sehr günstig erwiesen hat.

Alternativ zu dem beschriebenen Ausführungsbeispiel kann das in Figur 1 dargestellte Spritzgußteil auch aus einem amorphen Thermoplast, wie z.B. Polyätherimid oder Polyäthersulfon bestehen. In diesem Fall sind die Verbindungsabschnitte 2 dann aber nicht als flexible Filmscharniere ausgebildet, sondern als unter Einwirkung von Wärme verformbare Scharniere. Die Verbindungsabschnitte 2 werden dabei bis zum Erreichen des Erweichungsbereiches des jeweiligen amorphen Thermoplasts erwärmt und dann zu der in Figur 4 dargestellten Form umgebogen. Nach der Abkühlung erhärten dann auch die Verbindungsabschnitte 2 wieder.

## Ansprüche

1. Dreidimensionale Leiterplatte mit mindestens zwei in verschiedenen Ebenen angeordneten starren Platinenabschnitten und biegbaren Verbindungsabschnitten zwischen benachbarten Platinenabschnitten, **dadurch gekennzeichnet,** daß Platinenabschnitte (1) und Verbindungsabschnitte (2) als einstückiges Spritzgußteil aus einer thermoplastischen Formmasse hergestellt sind, wobei die Verbindungsabschnitte (2) als Schwachstellen mit einer gegenüber der Stärke (S) der Platinenabschnitte (1) geringeren Stärke (s) ausgebildet sind.

2. Dreidimensionale Leiterplatte nach Anspruch 1, **dadurch gekennzeichnet,** daß das Spritzgußteil aus einer teilkristallinen oder flüssigkristallinen thermoplastischen Formmasse hergestellt ist und die Verbindungsabschnitte (2) als flexible Filmscharniere ausgebildet sind.

3. Dreidimensionale Leiterplatte nach Anspruch 1, **dadurch gekennzeichnet,** daß das Spritzgußteil aus einer amorphen thermoplastischen Formmasse hergestellt ist und die Verbindungsabschnitte (2) als unter Einwirkung von Wärme biegbare Schwachstellen ausgebildet sind.

4. Dreidimensionale Leiterplatte nach einem der vorhergehenden Ansprüche,

**dadurch gekennzeichnet,**

daß die Verbindungsabschnitte (2) eine Stärke (s) von maximal 0,6 mm aufweisen.

5. Dreidimensionale Leiterplatte nach einem der Ansprüche 1 bis 3,

**dadurch gekennzeichnet,**

daß die Verbindungsabschnitte (2) eine Stärke (s) von maximal 0,3 mm aufweisen.

6. Dreidimensionale Leiterplatte nach einem der Ansprüche 1 bis 3,

**dadurch gekennzeichnet,**

daß die Verbindungsabschnitte (2) eine Stärke (S) von 0,1 bis 0,2 mm aufweisen.

7. Dreidimensionale Leiterplatte nach einem der Ansprüche 4 bis 6,

**dadurch gekennzeichnet,**

daß die Platinenabschnitte (1) eine Stärke (5) zwischen 0,9 und 1,6 mm aufweisen.

8. Dreidimensionale Leiterplatte nach einem der vorhergehenden Ansprüche,

**dadurch gekennzeichnet,**

daß die Platinenabschnitte (1) spritzgießtechnisch mitgeformte Kontaktierungslöcher (6) besitzen.

9. Dreidimensionale Leiterplatte nach einem der vorhergehenden Ansprüche,

**dadurch gekennzeichnet,**

daß die Platinenabschnitte (1) spritzgießtechnisch mitgeformte Fügehilfen (7, 8) besitzen.

10. Dreidimensionale Leiterplatte,

**dadurch gekennzeichnet,**

daß die Platinenabschnitte (1) spritzgießtechnisch mitgeformte Montagehilfen (9, 10) besitzen.

FIG 1

FIG 2

FIG 3

FIG 4